# EUROPEAN PATENT SPECIFICATION

(11) **EP 1 996 466 B1**
(45) Date of publication and mention of the grant of the patent: **12.09.2012**
(21) Application number: 07808987.7
(22) Date of filing: 28.02.2007
(51) Int. Cl.: B64F 1/36

(54) **INTEGRATED VERIFICATION AND SCREENING SYSTEM**
INTEGRIERTES VERIFIZIERUNGS- UND SCREENINGSYSTEM
SYSTÈME DE VÉRIFICATION ET DE CRIBLAGE INTÉGRÉ

(30) Priority: 10.03.2006 US 781057 P; 20.03.2006 US 385231
(43) Date of publication of application: 03.12.2008
(60) Divisional application: 11173114.7
(73) Proprietor: GE Security, Inc., Bradenton, FL 34202 (US)
(72) Inventor: CROWLEY, Christopher W., San Diego, CA 92122 (US); TRAMMELL, Hoke Smith., III, San Diego, CA 92119 (US); CZIPOTT, Peter Victor, San Diego, CA 92126 (US); COOKE, Dennis Charles, Newark, CA 94560-1012 (US)
(74) Representative: Smaggasgale, Gillian Helen
(86) International application number: PCT/US2007/005154
(87) International publication number: WO 2007/139603

(56) References cited:
- WO-A-00/28492
- WO-A-92/21987
- WO-A-2004/111963
- DE-A1- 2 934 966
- US-A- 4 818 854
- US-A- 4 821 118
- US-A- 5 600 303
- US-A1- 2003 085 348
- US-A1- 2003 171 939
- US-A1- 2005 019 220
- US-A1- 2005 167 484
- US-A1- 2006 017 439
- US-A1- 2006 042 407

## Description

### BACKGROUND OF THE INVENTION

This invention relates generally to personnel or baggage screening systems, and more particularly to, an integrated passenger identity verification and screening kiosk.

The Transportation Security Administration (TSA) has recently mandated more stringent inspection procedures be implemented by the travel industry to reduce the possibility of passengers boarding a carrier such as a plane, for example, carrying concealed weapons, explosives, or other contraband. To facilitate preventing passengers boarding a plane carrying concealed weapons, explosives, etc., the TSA requires that all passengers be screened prior to boarding the aircraft.

For example, passengers arriving at the airport terminal first submit to a manual verification process that generally includes presenting their boarding pass and a form of identification such as a driver's license or passport, for example, to security personnel. The security personnel then manually verify that the passenger has a valid boarding pass, the name on the identification corresponds to the name on the boarding pass, and that the picture on the license or passport corresponds to the passenger presenting the license and boarding pass to the security personnel.

After the manual verification process is completed, the passenger is requested to walk through a metal detector to ensure that the passenger is not carrying any concealed weapons. While the metal detector is reasonably effective at detecting specific quantities of metal, the metal detector can not distinguish between a possible weapon or other non-threatening items such as shoes that may include metallic portions. As a result, security personnel frequently request that passengers remove their shoes and place their shoes into the baggage screening system such that security personnel can visually verify the metallic object prior to the passenger boarding the plane and to also ascertain whether the shoes may conceal any explosive material or devices. Passengers are also asked to remove coats and jackets, passing them through the baggage screening system. This has the effect of making it easier for checkpoint personnel to observe possible concealed objects, such as explosives, under their remaining clothes, which are now less bulky and thus less likely to obscure the presence of concealed items.

As such, at least one known airport screening system relies on manual observations to verify the identity of the passenger and also utilizes electronic scanners and metal detectors to ascertain whether the passenger or the luggage includes any weapons or explosives. Moreover, each passenger is subjected to the same level of screening without regard to the threat that may be posed by the passenger. As a result, the known system is time-consuming for the passengers, and does not alert the security personnel when a low threat passenger or high threat passenger is being screened such that the security personnel may either increase or decrease the level of screening that the passenger or the passenger's personal effects are subjected to.

WO 2004/111963 describes a combined system user interface which may be configured with an advance technology screening checkpoint which is a passenger-friendly high performance system for screening passages and carry-on items to detect assembled bombs, bomb components, metallic and non-metallic weapons and other contraband items. The combined systems user interface may include a baggage, passenger and secondary screening status regions. The baggage screening status region displays screening information generated by an explosive screening system and a baggage imaging system while the passenger screening status region displays screening information generated by an explosive detection portal and a metal detection portal. WO 00/28492 describes a self-service terminal comprising a non-contact interface for enabling a user to interact with the terminal without requiring physical contact with the terminal, a biometric sensor for establishing the identity of the user by sensing a physical trait or characteristic of the user, and aprocessor for controller the terminal. The interface may utilise speech recognition and generation.

### BRIEF DESCRIPTION OF THE INVENTION

According to the present invention there is provided an inspection system, comprising:
a kiosk;
a passenger identity verification system within the said kiosk;
a passenger screening system within said kiosk; and
a computer coupled to said passenger identity verification system and said passenger screening system, said computer configured to receive information from said passenger identity verification system and operate said passenger screening system based on said information,
characterized in that:
   said kiosk comprises a floor and at least two sidewalls extending substantially vertically from said floor.

According to a second aspect of the present invention there is provided a method for inspecting a subject within a kiosk that includes a plurality of passenger identity verification systems, a passenger screening system, and a computer coupled to the passenger identity verification systems and the passenger screening system, the computer configured to receive information from at least one of the plurality of passenger identity verification systems and operate the passenger screening system based on the information, said method comprising:
prompting a passenger to select one of the plurality of passenger identity
verification systems;
operating the selected passenger identity verification system based on a passenger's input; and
transmitting the information generated by the selected passenger identity verification system to the computer;
characterized in that said method further comprises:
receiving the passenger into the kiosk including the passenger screening system, the passenger screening system including a floor and at least two electrically conductive sidewalls extending substantially vertically from the floor; and
operating the passenger screening system based on the information received from the computer.

### BRIEF DESCRIPTION OF THE DRAWINGS

Figure 1 is a perspective view of an exemplary kiosk system;
Figure 2 is a second perspective view of the kiosk system shown in Figure 1;
Figure 3 is a side section view of the kiosk system shown in Figure 1;
Figure 4 is a simplified block diagram of an exemplary kiosk security system that includes a first modality and a second modality;
Figure 5 is a schematic illustration of an exemplary Quadrupole Resonance (QR) screening system that may be utilized with the kiosk shown in Figures 1-4;
Figure 6 is a perspective view of the kiosk shown in Figures 1-3 including the screening system shown in Figure 5;
Figure 7 is a schematic illustration of a portion of the screening system shown in Figure 6;
Figure 8 is a schematic illustration of an exemplary screening system that may be utilized with the kiosk shown in Figures 1-4;
Figure 9 is a schematic illustration of an exemplary screening system that may be utilized with the kiosk shown in Figures 1-4;
Figure 10 is a schematic illustration of an exemplary screening system that may be utilized with the kiosk shown in Figures 1-4;
Figure 11 is a schematic illustration of an exemplary screening system that may be utilized with the kiosk shown in Figures 1-4;
Figure 12 is a schematic illustration of an exemplary screening system that may be utilized with the kiosk shown in Figures 1-4;

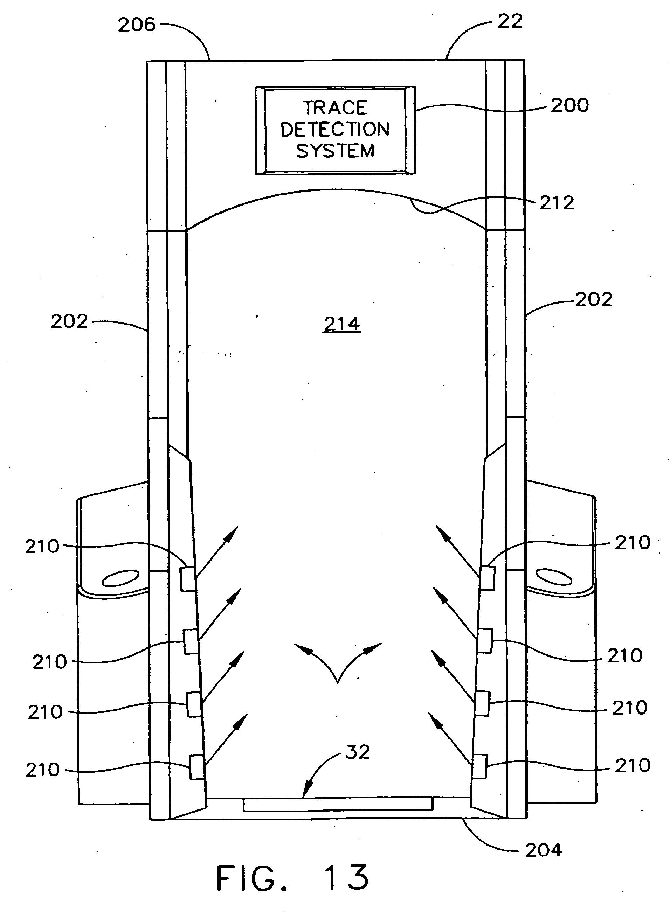

Figure 13 is a schematic illustration of an exemplary screening system that may be utilized with the kiosk shown in Figures 1-4;

### DETAILED DESCRIPTION OF THE INVENTION

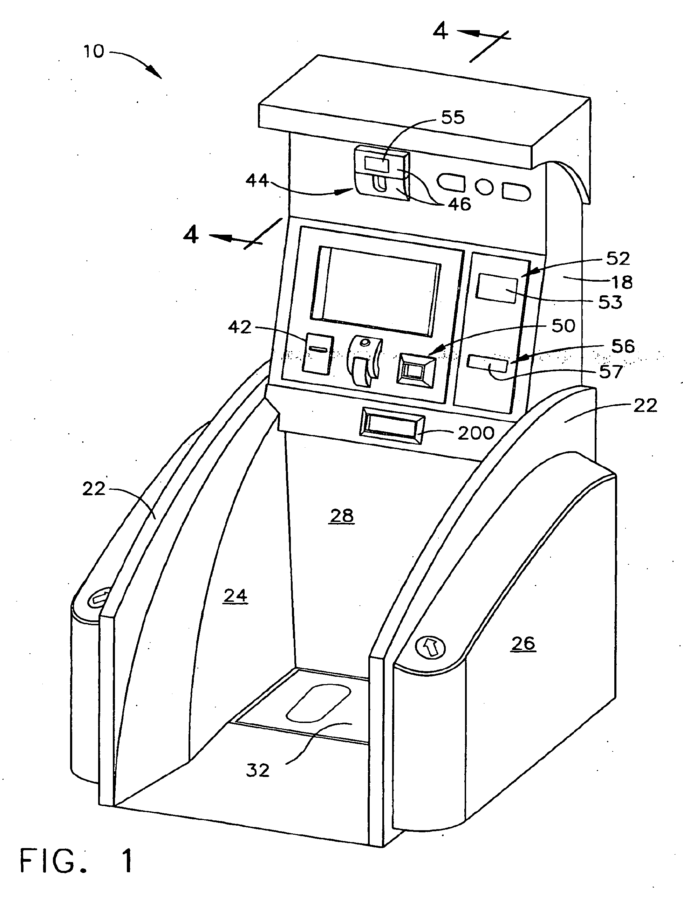

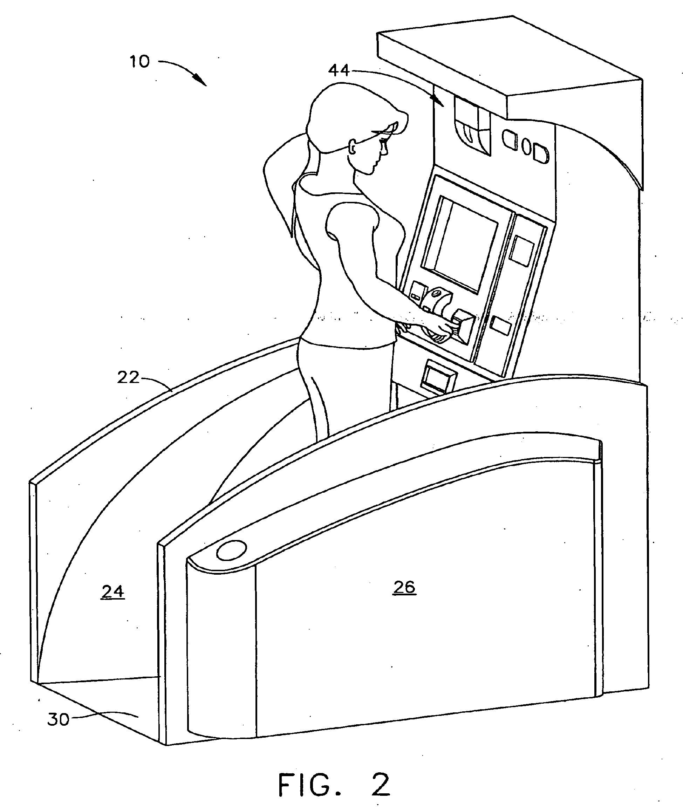

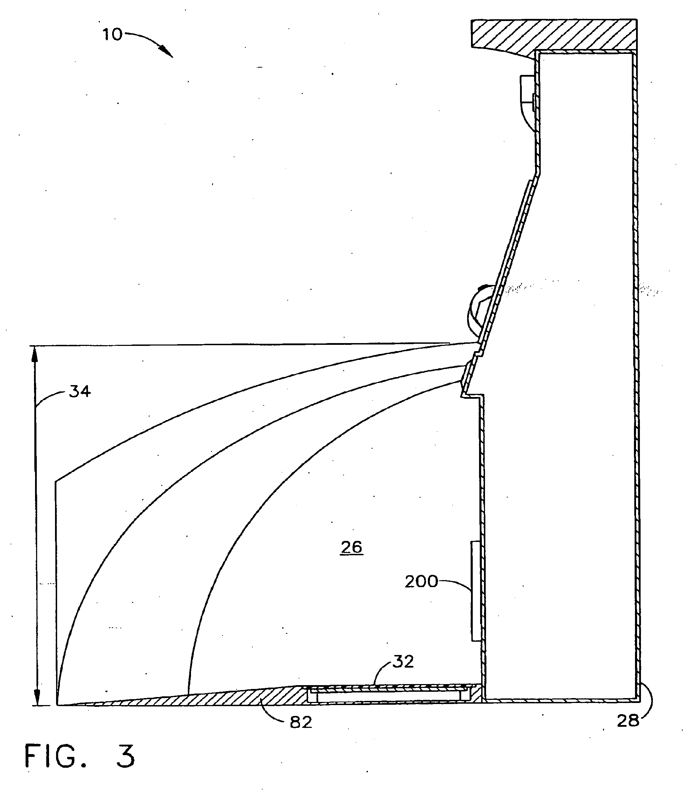

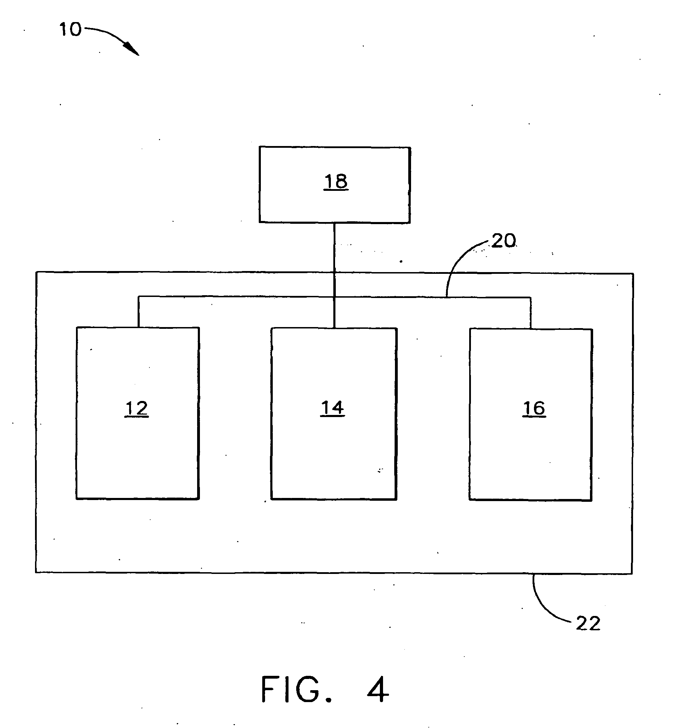

Figure 1 is a perspective view of an exemplary system 10, Figure 2 is a second perspective view of the kiosk system shown in Figure 1, Figure 3 is a side section view of system 10 shown in Figure 1, and Figure 4 is a simplified schematic illustration of system 10. In the exemplary embodiment, system 10 includes at least a first modality 12 referred to herein as passenger verification system 12 and a second modality 14 referred to herein as passenger screening system 14. Optionally, system 10 includes at least one additional modality 16 that may be utilized in conjunction with modality 12 and/or modality 14. System 10 also includes at least one computer 18, and a communications bus 20 that is coupled between modality 12, modality 14, modality 16 and computer 18 to enable operator commands to be sent to at least one of modality 12, modality 14, and/or modality 16 and to allow outputs generated by modality 12, modality 14, and/or modality 16 to be delivered to computer 18 and thus utilized by computer 18 for data analysis or utilized by an operator of computer 18. In one embodiment, modality 12, modality 14, and/or modality 16 are hardwired to computer 18. In another embodiment, communications bus 20 is a local area network. Optionally, communications bus 20 includes an internet connection.

As shown in Figure 4, modality 12, modality 14, and modality 16 are integrated into a single screening system 10. In the exemplary embodiment, modality 12, modality 14, and modality 16, and computer 18 are each housed within a single kiosk or housing 22. Optionally, computer 18 is housed separate from kiosk 22 and electrically coupled to modality 12, modality 14, and modality 16, utilizing bus 20. As used herein, a kiosk is defined as a relatively small area that is at least partially enclosed by at least one wall.

In the exemplary embodiment, kiosk 22 includes a first wall 24, a second wall 26 that is positioned substantially parallel to first wall 24, and a third wall 28 that is positioned substantially perpendicular to first and second walls 24 and 26, respectively. Kiosk 22 also includes a floor 30 extending between first, second, and third walls 24, 26, and 28, that, in one exemplary embodiment, includes an inductive sensor unit 32 that is described in further detail below. For example, and as shown in Figures 1 and 2, the three walls, 24, 26, and 28 define a single opening such that a passenger may enter and exit kiosk 22 through the same opening. Optionally, kiosk 22 may include two walls 24 and 26 such that the passenger may enter kiosk 22 through a first opening, traverse through kiosk 22, and exit kiosk 22 through a second opening. In one embodiment, the kiosk walls each have a height 34 of between approximaely 28 - 42 inches (71.1 - 106.7 cm). The embodiments of Figures 1, 2 and 3 show the left and right walls 24 and 26 formed with an approximate arcuate shape having a radius which approximates the height of the walls. Note that walls 24 and 26 have been optionally truncated at the entrance. Truncating walls 24 and 26 facilitates the movement of people into and out of system 10, and further extends the notion of openness of the inspection system. Optionally, kiosk walls 24 and 26 have a height 34 that is greater than a height of a typical passenger, i.e. like a phone booth for example, such that the entire passenger's body may be screened.

In the exemplary embodiment, modality 12, modality 14, and modality 16 may be implemented utilizing a plurality of technologies, a few examples of which are illustrated in Table I shown below.

**Table I**

| Modality 12 Passenger Identification Verification | Modality 14 Passenger Screening | Modality 16 Other services |
|---|---|---|
| Card reader | Quadrupole resonance (QR): shoes/lower leg | Boarding pass inspection (verify date, gate) |
| Keypad entry and lookup table (local or on internet) | Metal detection (MD): shoes/lower leg | Check-in (receive boarding pass) |
| Iris scan | Trace detection of explosives (T): fingertip | Seat selection/change |
| Fingerprint scan | Whole-body QR | Vending (coffee, trip insurance, etc.) |
| Handprint | Whole-body Metal Detection | Internet access |
| Facial image recognition | Whole-body Trace detection | |
| Voice recognition | Millimeter-wave imaging | |
| | Terahertz spectroscopy and/or imaging | |
| | Ultrasonic inspection or imaging | |
| | Backscatter X-ray imaging | |
| | Radar reflectometry (e.g., S-band) or imaging | |
| | Behavioral/physiological indicators | |

As shown in Table I, modality 12 is utilized to perform a passenger verification to properly verify the true identity of any passenger seeking to board the aircraft. For example, modality 12 may be implemented utilizing a card reader system 40 whereby passenger information may be encoded on a magnetic strip, optical read codes, an RF-read memory chip, or other embedded media. Modality 12 may also include biometric means to verify that the person presenting the card is the same individual whose identity is encoded on the card.

Passenger verification modality 12 may be implemented utilizing a keypad entry system 42 wherein a passenger enters a keycard into a receptacle provided with kiosk 22, modality 12 compares the keycard information with information that is stored within a database, for example a database stored within computer 18, and then either verifies the passenger identity or issues an alarm indication that the passenger's identity cannot be verified.

Passenger verification modality 12 may be implemented utilizing an exemplary biometric scan device 44 such as, but not limited to an iris scan device 44, to generate biometric information that is then compared to the information on the Registered Traveler's registration card in order to verify that the person with the card is the person to whom the card in fact belongs. In the exemplary embodiment, biometric device 44 includes an illuminating device 46 that directs light having desired characteristics to the eye under observation such that at least one of the iris and/or pupil of the eye under observation take a characteristic shape. The exemplary iris scan device 44 also includes a light imaging apparatus (not shown) to generate an image of the iris and/or pupil. The generated image is then compared to a verified image that may be stored within computer 18 to identify the eye and thus verify the identity of the passenger. It should be realized that in the exemplary embodiment, the generated images described herein are computer generated images that are stored within the computer and not physical images. Specifically, the systems described herein generate an electronic image that is compared to an electronic image stored within the system to verify the identity of the passenger.

Passenger verification modality 12 may be implemented utilizing a fingerprint scan device 50 wherein a passenger places a finger on the fingerprint scan device 50 such that the device obtains an image of the fingerprint of the passenger being verified. The generated image is then compared to a verified image of the fingerprint that may be stored within computer 18 in order to identify the fingerprint and thus verify the identity of the passenger.

Passenger verification modality 12 may be implemented utilizing a hand scanning device 52 wherein a passenger places their hand on the scan device 53. The device is then activated to scan the passenger' hand and thus obtain an image of the passenger's hand. The generated image is then compared to a verified image that may be stored within computer 18 in order to identify the handprint or other hand shape parameterization and thus verify the identity of the passenger.

Passenger verification modality 12 may be implemented utilizing a facial image recognition system 54 that includes an illuminating or scanning device 55 that is configured to generate an image or parameterization of the passenger's facial features. The generated image is then compared to a verified image that may be stored within computer 18 in order to identify the facial features and thus verify the identity of the passenger.

Passenger verification modality 12 may also be implemented utilizing a voice recognition system 56 that includes a microphone 57 wherein the passenger provides a voice sample that is compared to a verified voice sample that may be stored within computer 18 in order to identify the identity of the passenger.

It should be realized that the above described verification modalities 12 each generally require a passenger to be prescreened in order to generate the information that is stored within computer 18. For example, passengers may participate in the government's Registered Traveler Program whereby an initial, relatively thorough, screening of the passenger is conducted to generate information about the passenger that may be utilized by system 10 at a later date. As such, the passenger may choose to have a fingerprint scan completed, an iris scan, a hand scan, a voice scan, and/or a facial recognition scan completed. The information collected during the prescreen procedure is then stored within or provided to system 10, e.g. via a card reader reading a registration card, such that when a passenger enters kiosk 22, the verified information may be compared to the information presented by the passenger within kiosk 22 to facilitate reducing the amount of time to complete passenger screening and thus improve the convenience of passenger screening. Moreover, prescreening facilitates shifting limited security resources from lower-risk passengers to passengers that have not be prescreened.

When the passenger's identity has been verified using modality 12 this information may be utilized by system 10 to determine the level of passenger threat screening that may be conducted on the passenger utilizing modality 14. For example, the results of this screening may be used to affect the passenger's subsequent traversal of the remainder of the checkpoint (metal detector portal, X-ray system, hand wanding, pat-down, trace detection, etc). For example, system 10 may determine that based on the passenger's verified identity as determined by modality 12 that no threat screening is required to be accomplished by modality 14. Optionally, system 10 may determine that a limited or full threat screening is required on the passenger. As described herein, since modality 14 is housed within the same kiosk, i.e. kiosk 22, as passenger screening modality 14, modality 14 may accomplish either a metal detection screening and/or an explosives screening of at least a portion of the passenger without the passenger exiting the kiosk thus decreasing the amount of time required to verify the passenger and perform passenger screening, thus further improving convenience to the passenger.

In one exemplary embodiment, passenger screening modality 14 may be implemented utilizing a quadrupole resonance (QR) detection system 60 that utilizes quadrupole resonance to detect explosives such as, but not limited to C4, Semtex, Detasheet, TNT, ANFO, and/or HMX since the quadrupole resonance signature of these explosives is unique and measurable in seconds.

As such, Nuclear Quadrupole Resonance (NQR) is a branch of radio frequency spectroscopy that exploits the inherent electrical properties of atomic nuclei and may therefore be utilized to detect a wide variety of potentially explosive materials. For example, nuclei having non-spherical electric charge distributions possess electric quadrupole moments. Quadrupole resonance arises from the interaction of the nuclear quadrupole moment of the nucleus with the local, applied electrical field gradients produced by the surrounding atomic environment. Any chemical element's nucleus which has a spin quantum number greater than one half can exhibit quadrupole resonance. Such quadrupolar nuclei include: ⁷Li, ⁹Be, ¹⁴N, ¹⁷O, ²³Na, ²⁷Al, ³⁵Cl, ³⁷Cl, ³⁹K, ⁵⁵Mn, ⁷⁵As, ⁷⁹Br, ⁸¹Br, ¹²⁷I, ¹⁹⁷Au, and ²⁰⁹Bi. Many substances containing such nuclei, approximately 10,000, have been identified that exhibit quadrupole resonance. It so happens that some of these quadrupolar nuclei are present in explosive and narcotic materials, among them being ¹⁴N, ¹⁷O, ²³Na, ³¹Cl, ³⁷Cl, and ³⁹K. The most studied quadrupolar nucleus for explosives and narcotics detection is nitrogen. In solid materials, electrons and atomic nuclei produce electric field gradients. These gradients modify the energy levels of any quadrupolar nuclei, and hence their characteristic transition frequencies. Measurements of these frequencies or relaxation time constants, or both, can indicate not only which nuclei are present but also their chemical environment, or, equivalently, the chemical substance of which they are part.

When an atomic quadrupolar nucleus is within an electric field gradient, variations in the local field associated with the field gradient affect different parts of the nucleus in different ways. The combined forces of these fields cause the quadrupole to experience a torque, which causes it to precess about the electric field gradient. Precessional motion generates an oscillating nuclear magnetic moment. An externally applied radio frequency (RF) magnetic field in phase with the quadrupole's precessional frequency can tip the orientation of the nucleus momentarily. The energy levels are briefly not in equilibrium, and immediately begin to return to equilibrium. As the nuclei return, they produce an RF signal, known as the free induction decay (FID). A pick-up coil detects the signal, which is subsequently amplified by a sensitive receiver to measure its characteristics.

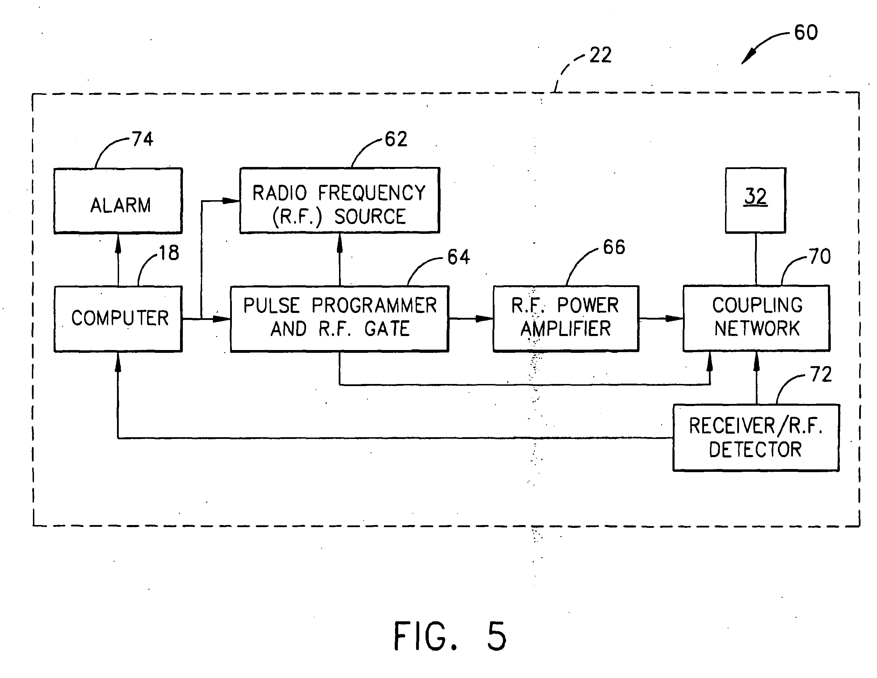

Figure 5 is a simplified schematic illustration of an exemplary quadrupole resonance system that may be utilized to implement screening modality 14. Quadrupole resonance system 60 includes a radio frequency source 62, a pulse programmer and RF gate 64 and an RF power amplifier 66 that are configured to generate a plurality of radio frequency pulses having a predetermined frequency to be applied to a coil such as sensor 32. A communications network 70 conveys the radio frequency pulses from radio frequency source 62, pulse programmer and RF gate 64 and RF power amplifier 66 to sensor 32 that, in the exemplary embodiment, is positioned within kiosk 22. The communications network 70 also conducts the signal to a receiver/RF detector 72 from sensor 32 after the passenger is irradiated with the radio frequency pulses.

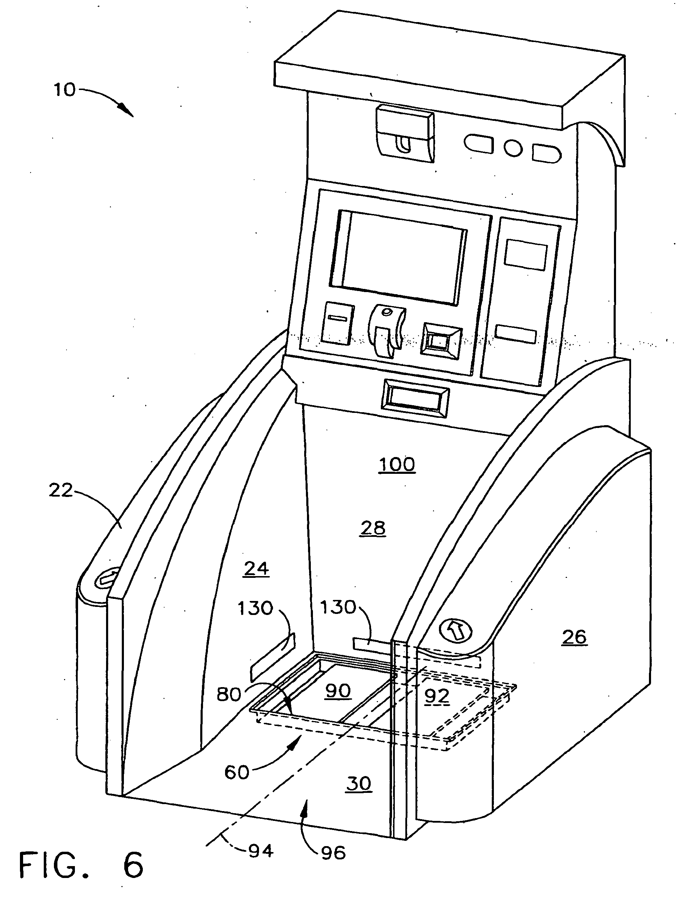

Figure 6 is a perspective view of kiosk 22 including QR system 60. In the exemplary embodiment, system 60 is configured as a kiosk shoe scanner. As stated above, system 60 includes an inductive sensor 32 that in the exemplary embodiment, is positioned proximate third wall 28 approximately between first and second walls 24 and 26. In accordance with this embodiment, inductive sensor 32 may be positioned within a recessed region 80 of floor 30, between an entrance ramp 82 and third wall 28. This recessed region 80 may also be referred to as the sensor housing. In Figure 6, the inductive sensor 32 has been omitted to show sensor housing 80, which is recessed within floor 30 of inspection system 60.

As shown in Figure 6, and in the exemplary embodiment, inductive sensor 32 may be implemented using two anti-symmetric current branches 90 and 92 that may be located on opposing sides of a medial plane 94 of system 60. Specifically, current branch 90 is positioned on one side of medial plane 94, while current branch 92 is positioned on the opposite side of medial plane 94.

Inductive sensor 32 may be configured in such a manner that both current branches 90 and 92 experience current flow that is generally or substantially parallel to the left and right walls 24 and 26. For example, the current branches 90 and 92 may be placed in communication with an electrical source (not shown in this figure). During operation, current flows through current branch 90 in one direction, while current flows through current branch 92 in substantially the opposite direction. The term "anti-symmetric current flow" may be used to refer to the condition in which current flows through the current branches in substantially opposite directions.

Inductive sensor 32 may be implemented using a quadrupole resonance (QR) sensor, a nuclear magnetic resonance (NMR) sensor, a metal detection sensor, and the like. For convenience only, various embodiments will be described with reference to the inductive sensor implemented as a QR sensor 32, but such description is equally applicable to other types of inductive sensors.

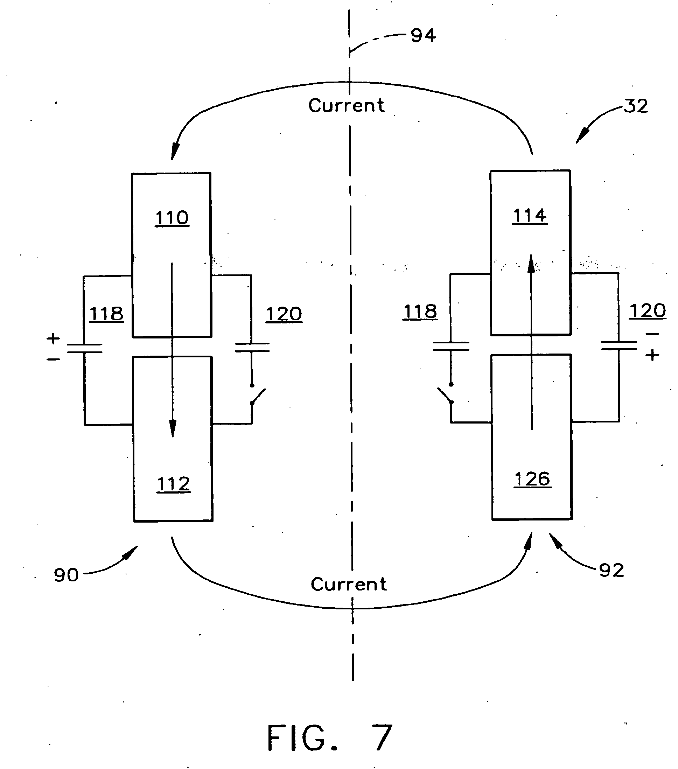

In the exemplary embodiment, current branches 90 and 92 collectively define a QR sheet coil that is shown as sensor 32 in Figure 7. For convenience only, further discussion of the QR sensor will primarily reference a "QR sheet coil," or simply a "QR coil". During a typical inspection process, a person enters the system at an entrance 96, and then stands within an inspection region defined by QR sensor 32. Specifically, the person may stand with their left foot positioned relative to current branch 90 and their right foot positioned relative to current branch 92. The QR sensor then performs an inspection process using nuclear quadrupole resonance (NQR) to detect the presence of a target substance associated with the person.

As shown in Figure 5, QR sensor 32 is in communication with the RF subsystem, defined generally herein to include radio frequency source 62, pulse programmer and RF gate 64, and RF power amplifier 66 which provides electrical excitation signals to current branches 90 and 92. The RF subsystem may utilize a variable frequency RF source to provide RF excitation signals at a frequency generally corresponding to a predetermined, characteristic NQR frequency of a target substance. During the inspection process, the RF excitation signals generated by the RF source may be introduced to the specimen, which may include the shoes, socks, and clothing present on the lower extremities of a person standing or otherwise positioned relative to the QR sensor 32. In some embodiments, the QR coil 32 may serve as a pickup coil for NQR signals generated by the specimen, thus providing an NQR output signal which may be sampled to determine the presence of a target substance, such as an explosive, utilizing computer 18, for example.

In the exemplary embodiment, QR sensor 32 utilizes an EMI/RFI (electromagnetic interference/radio frequency interference) shield to facilitate shielding sensor 32 from external noise, interference and/or to facilitate inhibiting RFI from escaping from the inspection system during an inspection process. In the exemplary embodiment, walls 24, 26, and 28 are configured to perform RF shielding for QR sensor 32. Specifically, walls 24, 26, and 28 are electrically connected to each other, to entrance ramp 82, and to sensor housing 80 to form an RF shield 100.

Each of the shielding components, i.e. walls 24, 26, and 28 may be fabricated from a suitably conductive material such as aluminum or copper. Typically, the floor components, i.e. ramp 82 and sensor housing 80 are welded together to form a unitary structure. Additionally, walls 24, 26, and 28 may also be welded to the floor components, or secured using suitable fasteners such as bolts, rivets, and/or pins. QR sensor 32 may be secured within sensor housing 80 using, for example, any of the just-mentioned fastening techniques. If desired, walls 24, 26, and 28, entrance ramp 82, and the QR sensor 32 may be covered with non-conductive materials such as wood, plastic, fabric, fiberglass, and the like.

Figure 7 is a simplified schematic illustration of the exemplary QR sensor 32 shown in Figure 6. Left current branch 90 is shown having upper and lower conductive elements 110 and 112, which are separated by a non-conductive region. Similarly, right current branch 92 includes upper and lower conductive elements 114 and 116, which are also separated by a non-conductive region. The left and right current branches 90 and 92 collectively define the QR coil of sensor 32, and may be formed from any suitably conductive materials such as copper or aluminum, for example.

No particular length or width for the current branches 90 and 92 is required. In general, each current branch may be dimensioned so that it is slightly larger than the object or specimen being inspected. Generally, current branches 90 and 92 are sized such that a person's left foot and right foot (with or without shoes) may be respectively placed in close proximity to the left and right current branches 90 and 92. This may be accomplished by the person standing over the left and right current branches. In this scenario, the left and right branches may each have a width of about 4-8 inches (10.2 - 20.3 cm) and a length of about 12 - 24 inches (30.5 - 61cm). It is to be understood that the terms "left" and "right" are merely used for expositive convenience and are not definitive of particular sides of the structure.

Upper and lower conductive elements 110 and 112 are shown electrically coupled by fixed-valued resonance capacitor 118 and tuning capacitor 120, which is a switched capacitor that is used to vary tuning capacitance. Upper and lower conductive elements 114 and 116 may be similarly configured.

Figure 7 also includes several arrows which show the direction of current flow through the left and right current branches 90 and 92. During operation, current flows through left current branch 90 in one direction, while current flows through right current branch 92 in substantially the opposite direction. The reason that current flows through the two current branches in opposite directions is because the left and right current branches 90 and 92 each have a different arrangement of positive and negative conductive elements. For instance, left current branch 90 includes a positive upper conductive element 110 and a negative lower conductive element 112. In contrast, right current branch 92 includes a negative upper conductive element 114 and a positive lower conductive element 116. This arrangement is one example of a QR sensor providing counter-directed or anti-symmetric current flow through the current branches.

In accordance with the exemplary embodiment, current flows between the left and right current branches 90 and 92 during operation since these components are electrically coupled via ramp 82 and the sensor housing 80. During operation, a person may place their left foot over left current branch 90 and their right foot over right current branch 92. In such a scenario, current is directed oppositely through each branch resulting in current flowing from toe to heal along left current branch 90, and from heal to toe along right current branch 92. In the exemplary embodiment, QR sensor 32 is positioned within sensor housing 80 to form a non-conductive gap between current branches of the QR sensor. This gap allows the magnetic fields to circulate about their respective current branches.

In contrast to conventional inductive sensor systems, the counter-directed magnetic fields generated by QR sensor 32 are well-attenuated and have a topography that is especially suited for use with a kiosk that includes a first wall 24, a second wall 26 that is opposite to first wall 24, and a third wall 28 that is substantially perpendicular to first and second walls 24 and 26, and a floor 30 that is connected to first wall 24, second wall 26, and third wall 28.

As an example of a practical application, the left and right current branches 90 and 92 may be positioned about 2-7 inches (5.1 - 17.8 cm) from respective walls 24, 26, and 28 using a plurality of non-conductive regions. In addition, current branches 90 and 92 may be positioned about 4-14 inches (10.2 - 35.6 cm) from each other using a non-conductive region. Operation of QR inspection system 60 in accordance with embodiments of the invention may proceed as follows. First, a person may be directed to enter QR inspection system 10 at entrance ramp 82. The person proceeds up entrance ramp 82 and stands with their feet positioned over QR sensor 32. To maximize the accuracy of the inspection process, the person may stand with their left foot positioned over left current branch 90 and their right foot over right current branch 92. The person will then be prompted by modality 12 to complete the verification screening process as described above. After the verification screening process is completed, modality 14 may prompt a passenger to ensure that their left foot is positioned over left current branch 90 and their right foot is positioned over right current branch 92. In the exemplary embodiment, labels are attached to the floor indication where the passenger's feet should be placed.

At this point, the lower extremities of the person are QR scanned by the inductive sensor 32 to determine the presence of a target substance such as, for example, an explosive, contraband, an illegal drug, a controlled substance, or a conductive object. In the case of QR detectable objects, this may be accomplished by a QR sensor providing RF excitation signals at a frequency generally corresponding to a predetermined, characteristic NQR frequency of the target substance. For example, RDX-based plastic explosives have a resonant frequency of approximately 3.410 MHz, while PETN-based plastic explosives have a resonant frequency of approximately 890 KHz. Note that the excitation frequency need not be exactly the same as the target substance NQR frequency, but it is typically within about 500-1000 Hz. The resonant frequencies of the various target substances that may be detected using NQR are well known and need not be further described. After the threat screening is completed, system 10 will direct the passenger to exit the kiosk 22.

In the exemplary embodiment, system 60 may also be configured to perform metal detection. Specifically, inductive sensor 32 may be configured as a pickup coil that is utilized to detect any inductive signals from the target specimen. To enhance the metal detection capability of system 60, system 60 may also include at least one, and preferably, a plurality of separate metal detection sensors 128 that are utilized in conjunction with inductive sensor 32. Each of the metal detection sensors 128 may be configured to detect conductive objects present within the vicinity of the lower extremities of the inspected person. These signals may be communicated to a suitable computing device for example computer 18.

In the exemplary embodiment, passenger screening modality 14 may be implemented utilizing a fingertip trace explosive detection system 220 (shown in Figure 1). Fingertip trace explosive detection system 220 is capable of detecting minute particles of interest such as traces of narcotics, explosives, and other contraband on the passenger's finger or hand for example. In the exemplary embodiment, detection system 220 is located proximate to a boarding pass scanner such that as the passenger scans the boarding pass, at least a portion of the passenger's hand approximately simultaneously passes over trace scanner 220. Optionally, the passenger is prompted to press a button to activate scanner 220 such that trace materials on the finger are collected and then analyzed by scanner 220.

In the exemplary embodiment, trace explosive detection system 220 includes an ion trap mobility spectrometer that is utilized to determine whether any substantially minute particles of interest such as traces of narcotics, explosives, and other contraband is found on the passenger's finger. For example, the ion trap mobility spectrometer is preferentially useful in identifying trace explosives or other contraband on a passenger's finger that may be indicative of the passenger recently manipulating explosives or other contraband and as such does not require imaging or localization.

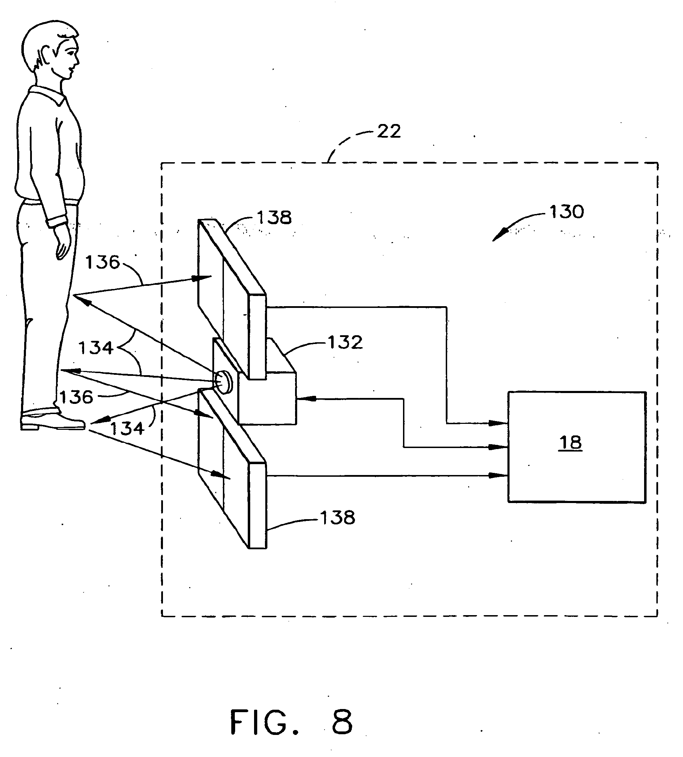

In the exemplary embodiment, passenger screening modality 14 may be implemented utilizing a backscatter X-ray imaging system 130 as shown in Figure 8. During operation, the scattered X-ray intensities are related to the atomic number of the material scattering the X-rays. Moreover, the intensity of the scattered X-rays is also related to the atomic number of the material the X-rays pass through before and after being scattered. For example, for materials having an atomic number that is less than 25, the intensity of X-ray backscatter, or X-ray reflectance, decreases with increasing atomic number. As a result, concealed objects, especially concealed objects fabricated utilizing a metallic material can be relatively easily detected using a backscatter X-ray imaging system because of the difference in atomic number between a metallic object and non-metallic objects. As a result, backscatter X-ray system 130 may be utilized to detect objects having a generally low atomic number.

In the exemplary embodiment, system 130 includes an X-ray source 132 that transmits at least one X-ray beam, or a plurality of X-ray beams 134 that are scattered or reflected from the passenger as beams 136 to at least one X-ray detector 138 that is positioned on the same side of the passenger as is X-ray source 132. As described herein, system 130 may be positioned in any of walls 24, 26, or 28, or optionally in floor 30. Signals generated by the X-ray detectors 138 are transmitted or routed to a computer such as computer 18 for example. Computer 18 then automatically determines whether the passenger has any concealed objects by comparing the generated data to data that is stored in a database within computer 18.

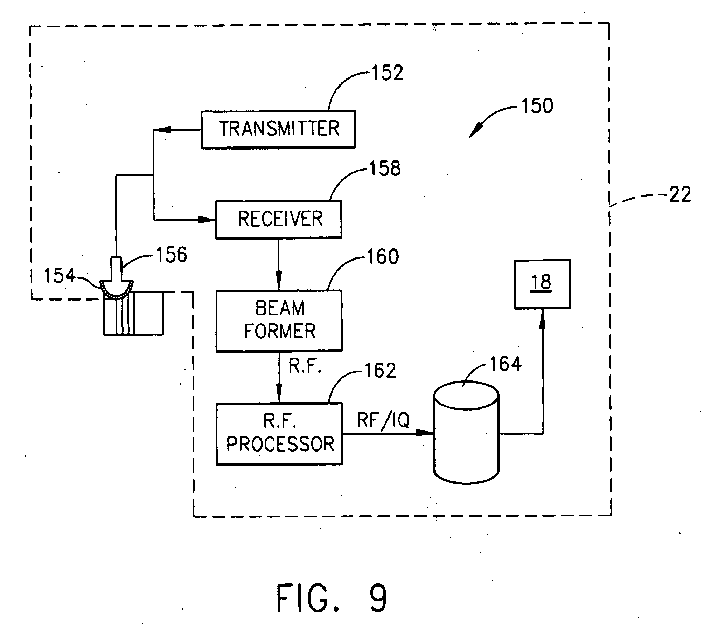

In the exemplary embodiment, passenger screening modality 14 may be implemented utilizing an ultrasonic inspection system. Figure 9 is a simplified schematic illustration of an exemplary ultrasonic inspection system 150 that includes a transmitter 152 that drives transducer elements 154 within a probe 156 to emit pulsed ultrasonic signals into a body. A variety of geometries may be used. The ultrasonic signals are back-scattered from structures within the body or preferably from metallic or explosive objects concealed on the body, to produce echoes that return to transducer elements 154. The echoes are received by a receiver 158. The received echoes are provided to a beamformer 160, which performs beamforming and outputs an RF signal. The RF signal is then transmitted to an RF processor 162. Alternatively, RF processor 162 may include a complex demodulator (not shown) that demodulates the RF signal to form IQ data pairs representative of the echo signals. The RF or IQ signal data may then be routed directly to an RF/IQ buffer 164 for temporary storage.

A user input device, such as computer 18 for example, may be used to control operation of ultrasound system 150 and to process the acquired ultrasound information (i.e., RF signal data or IQ data pairs) and prepare frames of ultrasound information for display on a display system coupled to computer 18. Computer 18 is adapted to perform one or more processing operations according to a plurality of selectable ultrasound modalities on the acquired ultrasound information. Acquired ultrasound information may be processed in real-time during a scanning session as the echo signals are received. Additionally or alternatively, the ultrasound information may be stored temporarily in RF/IQ buffer 164 during a scanning session and processed in less than real-time in a live or off-line operation. In the exemplary embodiment, probe 154 is housed on one of walls 24, 26, and 28 and/or within floor 30. In the exemplary embodiment, probe 154 is mounted in a fixed position. Optionally, probe 154 may be movable along a linear or arcuate path, while scanning the passenger within kiosk 22.

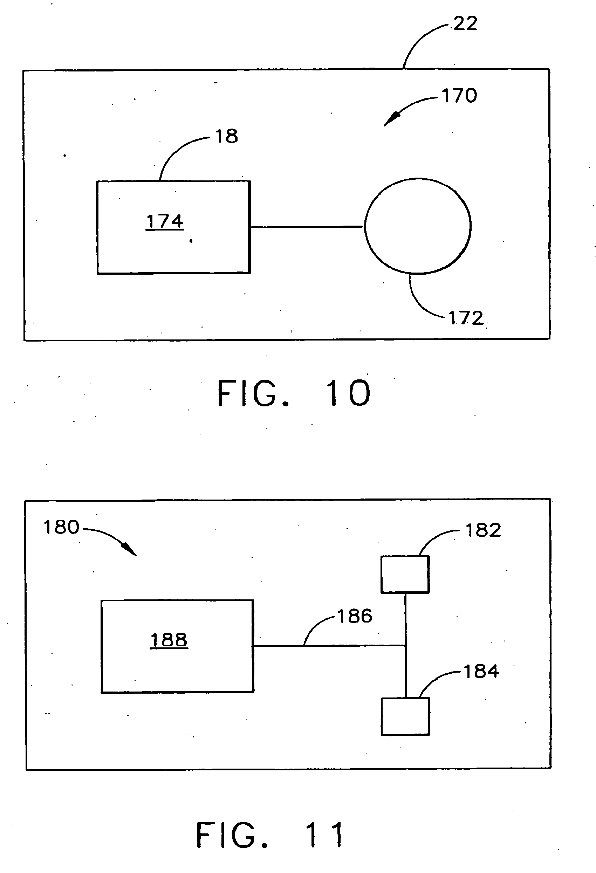

In the exemplary embodiment, passenger screening modality 14 may be implemented utilizing a millimeter wave imaging system. Figure 10 is a simplified schematic illustration of an exemplary millimeter wave imaging system 170. In the exemplary embodiment, millimeter wave imaging system 170 may be utilized to produce an image of a subject by directing millimeter-wave signals at the subject and detecting the reflected signal. In the exemplary embodiment, system 170 includes an antenna 172 and a controller 174 that is coupled to the antenna 172. In one embodiment, controller 174 is formed integrally with computer 18. Optionally, controller 174 is in communication with computer 18 via bus 20, for example. During operation, antenna 172 transmits electromagnetic radiation toward a passenger, and in response, the passenger emits or reflects electromagnetic radiation that is detected by the antenna apparatus. As described herein, the term passenger includes the person as well as any objects supported on the person, such as watches, keys, jewelry, pocket or other knives, coins, clothing accessories, guns, or any other objects that can be imaged. Information received from antenna 172 is then utilized by controller 174 and/or computer 18 to generate an image or indication that the passenger is carrying unauthorized materials or has a relatively significant quantity of metal concealed on the passenger's body.

Electromagnetic radiation may be selected from an appropriate frequency range, such as in the range of about 200 megahertz (MHz) to about one terahertz (THz), generally referred to herein as millimeter-wave radiation. Satisfactory imaging may be realized using electromagnetic radiation in the reduced frequency range of one gigahertz (GHz) to about 300 GHz. Radiation in the range of about 5 GHz to about 110 GHz may also be used for producing acceptable images. Such radiation may be either at a fixed frequency or over a range or set of frequencies using several modulation types, e.g. chirp, pseudorandom frequency hop, pulsed, frequency modulated continuous wave (FMCW), or continuous wave (CW).

In the exemplary embodiment, passenger screening modality 14 may be implemented utilizing a terahertz spectroscopy imaging system. Figure 11 is a simplified schematic illustration of an exemplary terahertz spectroscopy imaging system 180. In the exemplary embodiment, system 180 includes a first electrode 182 and a second electrode 184 that have been formed into the shape of a simple dipole antenna that includes a center-fed element 186 that is configured to transmit RF energy from first and second electrodes 182 and 184, and/or transmit RF energy to first and second electrodes 182 and 184 in the form of terahertz pulses via a transmitter 188. In the exemplary embodiment, first and second electrodes 182 and 184 are fabricated utilizing a semi-insulating gallium arsenide material for example.

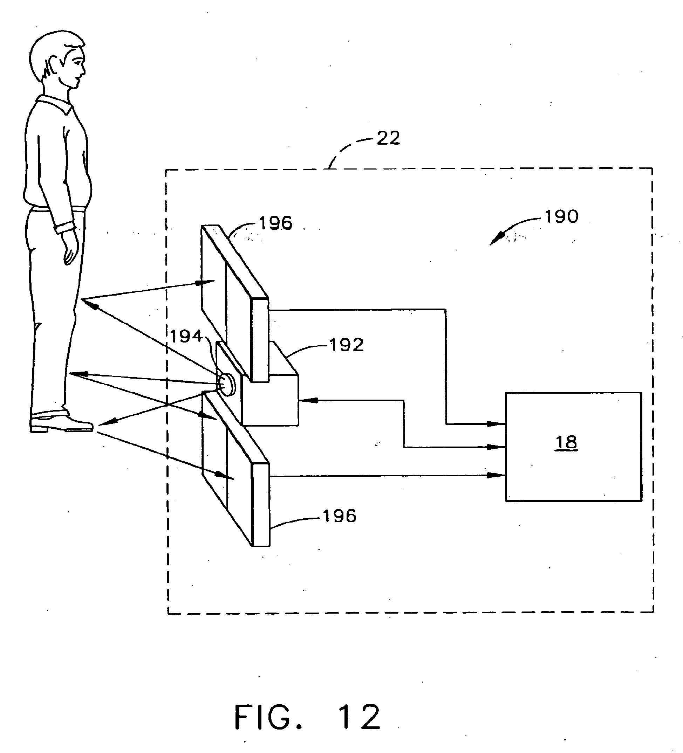

In the exemplary embodiment, passenger screening modality 14 may be implemented utilizing a Time Domain Reflectometry (TDR) system. Figure 12 is a simplified schematic illustration of an exemplary Time Domain Reflectometry system 190. In the exemplary embodiment, TDR system 190 a radio transmitter 192 which emits a short pulse of microwave energy, a directional antenna 194, and at least one radio receiver 196. During operation, transmitter 192 radiates a pulse which is directed toward the passenger. Receiver 196 then listens for an echo to return utilizing antenna 194 from the passenger. System 190, utilizing computer 18 for example, measures the time from the transmitted pulse until the echo returns and knowing the speed of light, the distance to the reflecting object may be easily calculated. The echo is further analyzed to determine additional details of the reflecting object to facilitate identifying the object.

Although the exemplary passenger screening modalities 14 described herein are generally directed toward scanning the lower region of the passenger while the passenger is still wearing shoes, it should be realized that at least some of modalities 14 may be implemented to scan the entire passenger with or without the passenger wearing shoes. Such systems include for example, whole body QR scanning, whole body metal detection, whole body trace explosive detection, and whole body metal detection.

In the exemplary embodiment, passenger screening modality 14 may be implemented utilizing a whole-body trace explosive detection system 200. For example, and referring to Figure 14, kiosk 22 may be enclosed by a plurality of vertical walls 202 extending from a floor 204 to a ceiling 206. If desired, kiosk 22 may further include a plurality of air jets 210. The jets are arranged to define four linear jet arrays with the jets in each array being vertically aligned. The jets may be disposed in portal 212 to extend from a lower location approximately at knee level (for example, about 1-2 feet (30.5 - 61 cm) from the ground) to an upper location approximately at chest level (for example, about 4-5 feet (122 - 152.4 cm) from the ground). Each jet may be configured to direct a short puff of air inwardly and upwardly into passage 214 of the portal.

The jets function to disturb the clothing of the human subject in the passage sufficiently to dislodge particles of interest that may be trapped in the clothing of the inspected person. However, the short puffs of air are controlled to achieve minimum disruption and minimum dilution of the human thermal plume. The dislodged particles then are entrained in the human thermal plume that exists adjacent the human subject. The air in the human thermal plume, including the particles of interest that are dislodged from the clothing, are directed to trace detection system 200 for analysis.

During operation, a person may be instructed to enter passage 214. Visual signals or voice prompts may be used to instruct the person to remain in the passage for the duration of the inspection process, which is typically about 5-10 seconds. The jets may then fire sequentially from bottom to top. More particularly, the four lower tier jets may fire simultaneously for about 50 ms. There then may be a pause of about 100 ms, and the four jets in the second tier may fire for about 50 ms. This process will continue until the four jets in the top tier have fired. Particles displaced by the jets will be entrained in the human thermal plume and will flow naturally upward through the hood-shaped ceiling 206 wherein the particles are utilized by trace detection system 200 to determine if the passenger is carrying any explosive articles or other contraband.. In another embodiment, whole body kiosk may be modified to include sensors that conduct whole body QR detection, whole body metal detection, and/or whole body trace explosive detection, as described above.

Although the exemplary embodiment illustrates a plurality of systems that may be utilized to implement screening modality 14, it should be realized a wide variety of systems may be utilized to identify any explosives or metallic objects carried by a passenger. Moreover, elements of each described system may be combined with elements of other described systems to further refine the screening process. Moreover, behavioral indications such as sweating, rapid eye movements, etc. may be utilized in conjunction with the systems described above to further optimize the screening process.

In the exemplary embodiment, modality 12 and/or modality 14 may be utilized in conjunction with a third modality 16 that, in the exemplary embodiment, may include other passenger services such as at least one of a boarding pass inspection system, a check-in system, a seat selection system, a vending system for vending coffee, insurance, etc., or internet access.

Described herein is a kiosk that combines any one or few of a number of passenger identity verification modalities with any one or a few of a number of threat screening modalities, with the option of adding one or a few other services: While the exemplary embodiment, illustrates the kiosk including a modality configured to scan only the lower portion of the passenger's legs and shoes, the kiosk may include a portal or phone booth-like enclosure to inspect the whole body.

While the invention has been described in terms of various specific embodiments, those skilled in the art will recognize that the invention can be practiced with modification within the scope of the claims.

## Claims

1. An inspection system (10), comprising:
a kiosk (22);
a passenger identity verification system (12) ;
a passenger screening system (14), and
a computer (18) coupled to said passenger identity verification system (12) and said passenger screening system (14), said computer (18) configured to receive information from said passenger identity verification system (12) and operate said passenger screening system (14) based on said information,
**characterized in that**:
the passenger identity verification system (12) and the passenger screening system (14) are both arranged within the said kiosk (22) and
said kiosk (22) comprises a floor (30) and at least two sidewalls (24 and 26) extending substantially vertically from said floor (30).

2. An inspection system in accordance with Claim 1 wherein said computer is coupled to a database storing previously verified passenger identity information, said passenger screening system comprises:
a radiation source configured to radiate at least a portion of the passenger; and
a detector array configured to receive radiation either passing through or reflected from the passenger and generate at least one image, said computer configured to determine a threat level of a passenger based on the generated image.

3. An inspection system in accordance with Claim 1 wherein said computer is coupled to a database storing previously verified passenger identity information, said passenger verification system comprises:
an input device configured to receive inputted identity information from the passenger, said computer configured to compare the inputted identity information with the verified passenger information to facilitate verifying the identity of a passenger.

4. An inspection system in accordance with Claim 1, further comprising:
an input device comprising a card reader configured to receive passenger inputted identity information from the passenger that is stored on at least one of a magnetic strip, an optical read code, and an RF-read memory chip, said computer configured to compare the inputted identity information entered into said card reader with the verified passenger information to facilitate verifying the identity of a passenger.

5. An inspection system in accordance with Claim 1 wherein said passenger verification system comprises:
an iris scan system comprising:
an illuminating device that directs light having desired characteristics to the passenger eye under observation; and
a light imaging apparatus configured to generate an image of the iris or pupil of the passenger, said computer configured to compare the generated image with the verified passenger information to facilitate verifying the identity of a passenger.

6. An inspection system in accordance with Claim 1 wherein said passenger verification system comprises:
a facial image recognition system comprising a scanning device configured to generate a facial image of the passenger under observation, said computer configured to compare the generated facial image with the verified passenger information to facilitate verifying the identity of a passenger.

7. An inspection system in accordance with Claim 1 wherein said passenger verification system comprises:
a voice recognition system comprising at least one microphone configured to generate voice recognition data of the passenger under observation, said computer configured to compare the voice recognition data with the verified passenger information to facilitate verifying the identity of a passenger.

8. An inspection system in accordance with Claim 1 wherein said computer is further configured to operate said passenger screening system at a predetermined security level based on said information.

9. An inspection system in accordance with Claim 1 wherein said passenger screening system (14) comprises a quadrupole resonance detection system (60) comprising:
an electromagnetic shield (100) comprising said at least two sidewalls (24 and 26), wherein said at least two sidewalls (24 and 26) are electrically conductive; and
an inductive sensor (32) positioned within said floor (30).

10. An inspection system in accordance with Claim 9 wherein said inductive sensor (32) is a metal detection sensor.

11. An inspection system in accordance with Claim 1 wherein said passenger screening system comprises one of a trace explosive detection system, a millimetre wave imaging system, a terahertz spectroscopy imaging system, an ultrasonic inspection system, a backscatter X-ray imaging system, and a radar reflectometry imaging system.

12. An inspection system in accordance with Claim 1 wherein said computer is further configured to perform at least one of verify passenger gate information, verify passenger boarding card information, assist a passenger in seat selection, connect the passenger to the Internet, and facilitate a passenger in purchasing insurance.

13. A method for inspecting a subject within a kiosk (22) that includes a plurality of passenger identity verification systems (12), a passenger screening system (14), and a computer (18) coupled to the passenger identity verification systems (12) and the passenger screening system (14), the computer (18) configured to receive information from at least one of the plurality of passenger identity verification systems (12) and operate the passenger screening system (14) based on the information, said method comprising:
prompting a passenger to select one of the plurality of passenger identity verification systems (12);
operating the selected passenger identity verification system (12) based on a passenger's input; and
transmitting the information generated by the selected passenger identity verification system (12) to the computer (18);
**characterized in that** said method further comprises:
receiving the passenger into the kiosk including the passenger screening system (14), the passenger screening system (14) including a floor (30), and at least two electrically conductive sidewalls (24 and 26) extending substantially vertically from the floor (30); and
operating the passenger screening system (14) based on the information received from the computer (18).

## Patentansprüche

1. Kontrollsystem (10), welches aufweist:
eine Kabine (22);
ein Passagier-Identitätsverifizierungssyste (12);
ein Passagier-Screeningsystem (14); und
einen Computer (18), der mit dem Passagier-Identitätsverifizierungssystem (12) und
dem Passagier-Screeningsystem (14) gekoppelt ist, wobei der Computer (18) dazu ausgelegt ist, Informationen von dem Passagier-Identitätsverifizierungssystem (12) zu empfangen und das Passagier-Screeningsystem (14) auf der Grundlage dieser Informationen zu betreiben,
**dadurch gekennzeichnet dass**
sowohl das Passagier-Identitätsverifizierungssystem (12) als auch das Passagier-Screeningsystem (14) in der Kabine (22) angeordnet sind, und
die Kabine (22) einen Boden (30) sowie mindestens zwei sich im Wesentlichen vertikal von dem Boden (30) aus erstreckende Seitenwände (24 und 26) aufweist.

2. Kontrollsystem nach Anspruch 1, wobei der Computer mit einer Datenbank gekoppelt ist, in der vorausgehend verifizierte Passagier-Identitätsinformationen gespeichert sind, wobei das Passagier-Screeningsyste folgendes aufweist:
eine Strahlungsquelle, die dazu ausgelegt ist, eine Strahlung auf zumindest eine Körperpartie des Passagiers hin abzugeben; und
eine Detektorenanordnung, die dazu ausgelegt ist, die Strahlung, die entweder durch den Passagier hindurchgetreten ist oder von diesem reflektiert wurde, aufzunehmen und mindestens eine Abbildung zu erzeugen, wobei der Computer dazu ausgelegt ist, ein Gefahrenpotenzial des Passagiers auf der Grundlage der erzeugten Abbildung zu bestimmen.

3. Kontrollsystem nach Anspruch 1, wobei der Computer mit einer Datenbank gekoppelt ist, in der vorausgehend verifizierte Passagier-Identitätsinformationen gespeichert sind, wobei das Passagier-Screeningsystem folgendes aufweist:
eine Eingabevorrichtung, die dazu ausgelegt ist, eingegebene Identitätsinformationen von dem Passagier zu empfangen, wobei der Computer dazu ausgelegt ist, die eingegebenen Identitätsinformationen mit den verifizierten Passagierinfbrmationen zu vergleichen, um die Verifizierung der Identität eines Passagiers zu erleichtern.

4. Kontrollsystem nach Anspruch 1, welches ferner aufweist:
eine Eingabevorrichtung mit einem Kartenleser, der dazu ausgelegt ist, von dem Passagier einzugebende Informationen, die auf mindestens einem von einem Magnetstreifen, einem optisch lesbaren Code und einem RF-lesbaren Speicherchip gespeichert sind, von dem Passagier zu erhalten, wobei der Computer dazu ausgelegt ist, die in den Kartenleser eingegebenen Identitätsinformationen mit den verifizierten Passagierinformationen zu vergleichen, um die Verifizierung der Identität eines Passagiers zu erleichtern.

5. Kontrollsystem nach Anspruch 1, wobei das Passagier-Verifizierungssystem folgendes aufweist:
ein Netzhautscansystem mit:
einer eleuchtungsvorrichtung, die Licht mit gewünschten Eigenschaften auf das zu begutachtende Auge eines Passagiers richtet; und
einer Ablichtungsvorrichtung, die dazu ausgelegt ist, ein Bild der Iris oder der Pupille des Passagiers zu erzeugen, wobei der Computer dazu ausgelegt ist, das erzeugte Bild mit den verifizierten Passagierinformationen zu vergleichen, um die Verifizierung der Identität eines Passagiers zu erleichtern.

6. Kontrollsystem nach Anspruch 1, wobei das Passagier-Verifizierungssystem folgendes aufweist:
ein Gesichtsbilderkennungssystem mit einer Abtastvorrichtung, die dazu ausgelegt ist, ein Gesichtsbild des zu begutachtenden Passagiers zu erzeugen, wobei der Computer dazu ausgelegt ist, das erzeugte Gesichtsbild mit den verifizierten Passagierinformationen zu vergleichen, um die Verifizierung der Identität eines Passagiers zu erleichtern.

7. Kontrollsystem nach Anspruch 1, wobei das Passagier-Verifizierungssystem folgendes aufweist:
ein Stimmerkennungssystem mit mindestens einem Mikrofon, das dazu ausgelegt ist, Stimmerkennungsdaten des zu begutachtenden Passagiers zu erzeugen, wobei der Computer dazu ausgelegt ist, die Stimmerkennungsdaten mit den verifizierten Passagierinformationen zu vergleichen, um die Verifizierung der Identität eines Passagiers zu erleichtern.

8. Kontrollsystem nach Anspruch 1, wobei der Computer ferner dazu ausgelegt ist, das Passagier-Screeningsyste auf der Grundlage der Informationen auf einer vorgegebenen Sicherheitsstufe zu betreiben.

9. Kontrollsystem nach Anspruch 1, wobei das Passagier-Screeningsystem (14) ein Quadrupol-Resonanzerfassungssystem (60) aufweist mit:
einer elektromagnetischen Abschirmung (100), welche die mindestens zwei Seitenwände (24 und 26) ausweist, wobei die mindestens zwei Seitenwände (24 und 26) elektrisch leitend sind; und
einem induktiven Sensor (32), der im Inneren des Bodens (30) angeordnet ist.

10. Kontrollsystem nach Anspruch 9, wobei der induktive Sensor (32) ein Metallerkennungssensor ist.

11. Kontrollsystem nach Anspruch 1, wobei das Passagier-Screeningsystem eines von einem Sprengstoffspurenerfassungssystem, einem Millimeterwellen-Bildgebungssystem, einem Terahertzspektroskopie-Bildgebungssystem, einem Ultraschalluntersuchungssystem, einem Röntgenscanner ("Backscatter X-Ray")-Bildgebungssystem und einem Radar-Reflektometrie-Bildgebungssystem aufweist.

12. Kontrollsystem nach Anspruch 1, wobei der Computer ferner dazu ausgelegt ist, mindestens eine der folgenden Aufgaben zu erfüllen: Verifizieren von Passagier-Gateinformationen, Verifizieren von Passagier-Bordkarteninformationen, Unterstützen eines Passagiers bei der Sitzwahl, Verbinden des Passagiers mit dem Internet, und Erleichtern des Erwerbs von Versicherungen durch den Passagier.

13. Verfahren zum Kontrollieren einer Person im Inneren einer Kabine (22), die eine Mehrzahl von Passagier-Identitätsverifizierungssystemen (12), ein Passagier-Screeningsystem (14) und einen mit dem Passagier-Identitätsverifizierungssystems (12) und dem Passagier-Screeningsystem (14) gekoppelten Computer (18) aufweist, wobei der Computer (18) dazu ausgelegt ist, Informationen von mindestens einem der Mehrzahl von Passagier-Identitätsverifizierungssystemen (12) zu empfangen und das Passagier-Screeningsystem (14) auf der Grundlage dieser Informationen zu betreiben, wobei das Verfahren folgendes umfasst:
Auffordern eines Passagiers, eines der Passagier-Identitätsverifizierungssysteme (12) auszuwählen;
Betreiben des ausgewählten Passagier-Identitätsverifizierungssystems (12) auf der Grundlage einer Eingabe durch den Passagier;
Übertragen der von dem ausgewählten Passagier-Identitätsverifizierungssystem (12) erzeugten Informationen an den Computer (18);
**dadurch gekennzeichnet, dass** das Verfahren ferner folgendes umfasst:
Empfangen des Passagiers in der Kabine, welche das Passagier-Screeningsystem (14) aufweist, wobei das Passagier-Screeningsystem (14) einen Boden (30) sowie mindestens zwei sich im Wesentlichen vertikal von dem Boden (30) aus erstreckende, elektrisch leitende Seitenwände (24 und 26) aufweist; und
Betreiben des Passagier-Screeningsystems (14) auf der Grundlage der von dem Computer (18) empfangenen Informationen.

## Revendications

1. Système d'inspection (10), comprenant :
un kiosque (22) ;
un système de vérification d'identité de passager (12) ;
un système de contrôle de passager (14) ; et
un ordinateur (18) couple audit système de vérification d'identité de passager (12) et
audit système de contrôle de passager (14), ledit ordinateur (18) configuré pour recevoir des informations en provenance dudit système de vérification d'identité de passager (12) et faire fonctionner ledit système de contrôle de passager (14) sur la base desdites informations,
**caractérisé en ce que** :
le système de vérification d'identité de passager (12) et le système de contrôle de passager (14) sont tous deux agencés à l'intérieur dudit kiosque (22) et
ledit kiosque (22) comprend un plancher (30) et au moins deux parois latérales (24 et 26) s'étendant de manière sensiblement verticale depuis ledit plancher (30).

2. Système d'inspection selon la revendication 1, dans lequel ledit ordinateur est couplé à une base de données stockant des informations d'identité de passager vérifiées précédemment, ledit système de contrôle de passager comprend :
une source de rayonnement configurée pour irradier au moins une partie du passager ; et
un groupement de détecteurs configuré pour recevoir le rayonnement soit traversant soit réfléchi depuis le passager et générer au moins une image, ledit ordinateur configuré pour déterminer un niveau de menace d'un passager sur la base de l'image générée.

3. Système d'inspection selon la revendication 1, dans lequel ledit ordinateur est couplé à une base de données stockant des informations d'identité de passager vérifiées précédemment, ledit système de vérification de passager comprend :
un dispositif d'entrée configuré pour recevoir des informations d'identité entrées en provenance du passager, ledit ordinateur configuré pour comparer les informations d'identité entrées avec les informations de passager vérifiées afin de faciliter la vérification de l'identité d'un passager.

4. Système d'inspection selon la revendication 1, comprenant en outre :
un dispositif d'entrée comprenant un lecteur de cartes configuré pour recevoir des informations d'identité de passager en entrée en provenance du passager qui sont stockées sur au moins un parmi une bande magnétique, un code à lecture optique, et
une puce de mémoire à lecture RF, ledit ordinateur configuré pour comparer les informations d'identité en entrée introduites dans ledit lecteur de cartes avec les informations de passager vérifiées afin de faciliter la vérification de l'identité d'un passager.

5. Système d'inspection selon la revendication 1, dans lequel ledit système de vérification de passager comprend :
un système de balayage de l'iris comprenant :
un dispositif illuminateur qui dirige une lumière ayant des caractéristiques souhaitées vers l'oeil du passager en cours d'observation ; et
un appareil d'imagerie lumineuse configuré pour générer une image de l'iris ou de la pupille du passager, ledit ordinateur configuré pour comparer l'image générée avec les informations de passager vérifiées afin de faciliter la vérification de l'identité d'un passager.

6. Système d'inspection selon la revendication 1, dans lequel ledit système de vérification de passager comprend :
un système de reconnaissance d'image faciale comprenant un dispositif de balayage configuré pour générer une image faciale du passager en cours d'observation, ledit ordinateur configuré pour comparer l'image faciale générée avec les informations de passager vérifiées afin de faciliter la vérification de l'identité d'un passager.

7. Système d'inspection selon la revendication 1, dans lequel ledit système de vérification de passager comprend :
un système de reconnaissance vocale comprenant au moins un microphone configuré pour générer des données de reconnaissance vocale du passager en cours d'observation, ledit ordinateur configuré pour comparer les données de reconnaissance vocale avec les informations de passager vérifiées afin de faciliter la vérification de l'identité d'un passager.

8. Système d'inspection selon la revendication 1, dans lequel ledit ordinateur est en outre configuré pour faire fonctionner ledit système de contrôle de passager à un niveau de sécurité prédéterminé sur la base desdites informations.

9. Système d'inspection selon la revendication 1, dans lequel ledit système de contrôle de passager (14) comprend un système de détection à résonance quadripolaire (60) comprenant :
un écran électromagnétique (100) comprenant lesdites au moins deux parois latérales (24 et 26), dans lequel lesdites au moins deux parois latérales (24 et 26) sont électriquement conductrices ; et
un capteur inductif (32) positionné à l'intérieur dudit plancher (30).

10. Système d'inspection selon la revendication 9, dans lequel ledit capteur inductif (32) est un capteur de détection de métaux.

11. Système d'inspection selon la revendication 1, dans lequel ledit système de contrôle de passager comprend un parmi un système de détection de traces d'explosifs, un système d'imagerie à ondes millimétriques, un système d'imagerie à spectroscopie térahertz, un système d'inspection ultrasonique, un système d'imagerie à rétrodiffusion des rayons X, et un système d'imagerie à réflectométrie radar.

12. Système d'inspection selon la revendication 1, dans lequel ledit ordinateur est en outre configuré pour effectuer au moins un parmi la vérification d'informations de porte de passager, la vérification d'informations de carte d'embarquement de passager, l'aide d'un passager à la sélection des places, la connexion du passager à Internet, et le fait de faciliter à un passager l'achat de l'assurance.

13. Procédé pour inspecter un sujet à l'intérieur d'un kiosque (22) qui comprend une pluralité de systèmes de vérification d'identité de passager (12), un système de contrôle de passager (14), et un ordinateur (18) couplé aux systèmes de vérification d'identité de passager (12) et au système de contrôle de passager (14), l'ordinateur (18) configuré pour recevoir des informations en provenance d'au moins un de la pluralité de systèmes de vérification d'identité de passager (12) et faire fonctionner le système de contrôle de passager (14) sur la base des informations, ledit procédé comprenant :
l'invitation d'un passager à sélectionner un de la pluralité de systèmes de vérification d'identité de passager (12) ;
le fonctionnement du système de vérification d'identité de passager (12) sélectionné sur la base d'une entrée d'un passager ; et
la transmission des informations générées par le système de vérification d'identité de passager (12) sélectionné à l'ordinateur (18) ;
**caractérisé en ce que** ledit procédé comprend en outre :
la réception du passager dans le kiosque comprenant le système de contrôle de passager (14), le système de contrôle de passager (14) comprenant un plancher (30), et au moins deux parois latérales électriquement conductrices (24 et 26) s'étendant de manière sensiblement verticale depuis le plancher (30) ; et
le fonctionnement du système de contrôle de passager (14) sur la base des informations reçues en provenance de l'ordinateur (18).
